# EUROPÄISCHE PATENTSCHRIFT

(11) **EP 2 620 044 B1**
(45) Veröffentlichungstag und Bekanntmachung des Hinweises auf die Patenterteilung: **31.12.2014**
(21) Anmeldenummer: 11770691.1
(22) Anmeldetag: 15.09.2011
(51) Int. Cl.: H05K 5/00, H01H 9/02

(54) **KUNSTSTOFFGEHÄUSE FÜR ELEKTRONISCHE GERÄTE, INSBESONDERE FÜR FERNSTEUERUNGEN**
PLASTIC HOUSING FOR ELECTRONIC DEVICES, IN PARTICULAR FOR REMOTE CONTROLS
BOÎTIER EN MATIÈRE PLASTIQUE POUR APPAREILS ÉLECTRONIQUES, EN PARTICULIER POUR TÉLÉCOMMANDES

(30) Priorität: 21.09.2010 DE 102010045944
(43) Veröffentlichungstag der Anmeldung: 31.07.2013
(73) Patentinhaber: FM Marketing GmbH, 5162 Obertrum am See (AT)
(72) Erfinder: MAIER, Ferdinand, A-5162 Obertrum am See (AT)
(74) Vertreter: von Bülow, Tam
(86) Internationale Anmeldenummer: PCT/EP2011/004628
(87) Internationale Veröffentlichungsnummer: WO 2012/038047

(56) Entgegenhaltungen:
- EP-A1- 1 553 610
- EP-A2- 0 881 867
- EP-A2- 1 843 367

## Beschreibung

Die Erfindung bezieht sich auf ein Kunststoffgehäuse für elektronische Geräte, insbesondere für Fernsteuerungen gemäß dem Oberbegriff des Patentanspruches 1.

Solche Gehäuse sind allgemein bekannt und im Handel erhältlich. Die Gehäuse bestehen aus einem ersten und einem zweiten Gehäuseteil, die auch als Oberschale und Unterschale bezeichnet werden können und deckungsgleiche Ränder aufweisen, die im montierten Zustand einander berühren. Das fertig montierte Gehäuse bildet einen Hohlraum, in dem elektrische und elektronische Bauteile angeordnet werden können. Zur Ausrichtung und Zentrierung von Ober- und Unterschale sind an einem der Gehäuseteile Zapfen und am anderen Gehäuseteil den Zapfen zugeordnete Bohrungen vorgesehen. Zur sicheren Befestigung der beiden Gehäuseteile werden üblicherweise zusätzliche Rasthaken oder Schrauben verwendet. Auch ist es üblich, die beiden Gehäuseteile an ihren Rändern miteinander zu verkleben oder zu verschweißen. Diese Verbindungsarten, wie Rasthaken, Verschrauben, Verkleben oder Verschweißen sind material- oder arbeitsaufwendig. Die am häufigsten verwendeten Rasthaken haben zudem den Nachteil, daß ein Einrasten der Rasthaken ein gewisses Spiel erfordert, mit der Folge, daß die beiden Gehäuseteile nicht fest miteinander verbunden sind, was zu einer verringerten Biege- und Torsionssteifigkeit des Gehäuses führt. Darüber hinaus können Verbindungen mit Rasthaken nicht mehr zerstörungsfrei gelöst werden, es sei denn, das Gehäuse hat im Bereich der Rasthaken Demontageöffnungen, um den Rasthaken aus seiner Verriegelungsstellung bewegen. Bei verklebten oder verschweißten Gehäuseteilen ist eine Demontage zerstörungsfrei überhaupt nicht möglich. Bei Verschraubung ist die Demontage zwar möglich. Eine stabile Verbindung von zwei Gehäuseteilen mit Verschraubungen wird jedoch nur dann erreicht, wenn man eine Vielzahl von Schrauben einsetzt. Üblicherweise werden jedoch nur vier bis maximal sechs Schrauben verwendet, so daß die Biege- und Torsionssteifigkeit des montierten Gehäuses nicht zufriedenstellend ist.

Aufgabe der Erfindung ist es daher, Kunststoffgehäuse der eingangs genannten Art dahingehend zu verbessern, daß mit verringertem Material- und/oder Montageaufwand ein stabiles und insbesondere biege- und torsionssteifes Gehäuse geschaffen wird, das besonders einfach zu montieren und zerstörungsfrei zu öffnen ist.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Die Grundidee der Erfindung besteht darin, die Verbindung allein durch Zapfen und zugeordnete Bohrungen herzustellen, die aufgrund besonderer Dimensionierung ein Verklemmen zwischen Zapfen und Bohrungen bewirkt. Hierzu sind einerseits die Durchmesser der Zapfen größer als die Durchmesser der zugeordneten Bohrungen und zwar vorzugsweise um etwa 0,7% bis 1%. Weiter sind die Abstände der Zapfen.zueinander und die Abstände der den Zapfen zugeordneten Bohrungen zueinander ungleich und zwar um ein solches Maß, daß die Zapfen zwar in die zugeordneten Bohrungen einsetzbar sind, sie jedoch aufgrund der ungleichen Abstände elastisch gegeneinander verspannt werden. Voraussetzung ist selbstverständlich, daß Zapfen und Bohrungen aus elastischem Material sind, was bei einem Kunststoffgehäuse aufgrund der Materialeigenschaften gegeben ist.

Nach einem bevorzugten Ausführungsbeispiel weichen die Abstände benachbarter Zapfen und die Abstände zugeordneter benachbarter Bohrungen um ca. 0,7% bis 1% des Durchmessers der Zapfen voneinander ab.

Nach einer weiteren Ausgestaltung der Erfindung sind die Zapfen und Bohrungen jeweils in geradlinigen Reihen nahe den Rändern der Gehäuseteile angeordnet. Dabei ist es von Vorteil, wenn die Abstände benachbarter Zapfen längs einer Reihe unter sich ungleich sind. Der Abstand der Zapfen vom Rand des Gehäuseteiles liegt vorzugsweise in der Größenordnung eines Zapfendurchmessers.

Die Zapfen und die Bohrungen sind vorzugsweise einstückig mit dem jeweiligen Gehäuseteil verbunden und zwar vorzugsweise mittels Versteifungsrippen. Beide Gehäuseteile können daher einstückig aus Kunststoff gespritzt werden. Bevorzugte Kunststoffe sind ABS (Acrylnitril-Butadiene-Styrol) oder Polycarbonat.

Im folgenden wird die Erfindung anhand eines Ausführungsbeispieles im Zusammenhang mit der Zeichnung ausführlicher erläutert. Es zeigt:
- Fig. 1: eine Seitenansicht eines Kunststoffgehäuses nach der Erfindung;
- Fig. 2: eine Ansicht der Innenseite eines ersten Gehäuseteiles;
- Fig. 3: eine Ansicht der Innenseite eines zweiten Gehäuseteiles;
- Fig. 4: eine vergrößerte Schnittansicht als Explosionsdarstellung der beiden Gehäuseteile der Fig. 2 und 3; und
- Fig. 5: eine vergrößerte Schnittansicht von Gehäuseteilen mit Zapfen und Bohrungen.

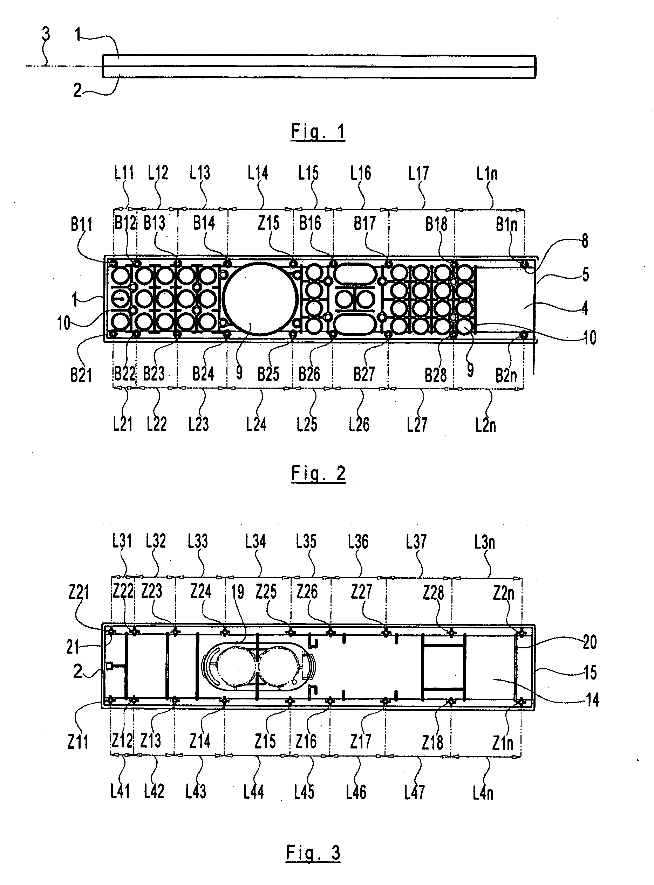

Fig. 1 zeigt eine Seitenansicht eines Kunststoffgehäuses mit einem ersten Gehäuseteil 1 und einem zweiten Gehäuseteil 2, die in einer Verbindungsebene 3 miteinander verbunden sind.

Fig. 2 zeigt eine Ansicht der Innenseite eines ersten Gehäuseteiles 1 am Ausführungsbeispiel eines Kunststoffgehäuses für eine Fernsteuerung. Das erste Gehäuseteil 1 hat einen im wesentlichen ebenen Boden 4, von dem ein ringsumlaufender Rand 5 im wesentlichen senkrecht absteht und dessen Endfläche 6 bei montiertem Kunststoffgehäuse in der Verbindungsebene 3 liegt. In der Endfläche 6 ist eine Vertiefung 7 ausgebildet, die beispielsweise halbkreisförmig sein kann.

Nahe dem umlaufenden Rand 5 sind einstückig mit dem Gehäuseteil 1 mehrere Hülsen 8 ausgebildet, die jeweils eine Bohrung B11 bis B1n und B21 bis B2n aufweisen. Die Bohrungen B11 bis B1n sind in einer geradlinigen Reihe nahe einer Längsseite des umlaufenden Randes 5 angeordnet, während die Bohrungen B21 bis B2n nahe der gegenüberliegenden Längsseite des umlaufenden Randes 5 angeordnet sind. Im dargestellten Ausführungsbeispiel sind die Bohrungen B11 bis B1n spiegelsymmetrisch zu den Bohrungen B21 bis B2n angeordnet. Die Mittelachsen der einzelnen Bohrungen haben zur jeweils benachbarten Bohrung einen Abstand L11 bis L1n bzw. L21 bis L2n. Die Abstände L11 und L21, L12 und L22 bis L1n und L2n sind jeweils gleich groß, während die Abstände L11, L12 ... bis L1n jeweils unterschiedlich groß sein können. So sind beispielsweise die Abstände L11 und L21 gleich groß jedoch die Abstände L11 und L12 unterschiedlich. Analoges gilt für die Abstände L21 zu L22 usw.

Das erste Gehäuseteil 1 hat eine Vielzahl von Durchbrüchen 9 im Boden 4, durch welche nicht dargestellte Bedientasten hindurchragen. Weiter hat das erste Gehäuseteil eine Vielzahl von senkrecht vom Boden 4 abstehenden Versteifungsrippen 10, um dem Gehäuseteil 1 trotz der vielen Durchbrüche 9 eine gewünschte Festigkeit zu geben.

Das zweite Gehäuseteil 2 hat ebenfalls einen im wesentlichen ebenen Boden 14, einen ringsumlaufenden, senkrecht vom Boden 14 abstehenden Rand 15, dessen Endfläche 16 bei montiertem Kunststoffgehäuse in der Verbindungsebene 3 liegt und mit der Endfläche 6 des ersten Gehäuseteiles in Berührung kommt. Entsprechend der Vertiefung 7 des ersten Gehäuseteiles 1 hat das zweite Gehäuseteil 2 einen daran angepaßten Vorsprung 17, der in diesem Fall ebenfalls halbkreisförmig ist. Auch das zweite Gehäuseteil 2 kann mehrere Versteifungsrippen 20 haben. Der Boden 14 kann ebenfalls einen Durchbruch 19 haben als Zugang zu einem Batteriefach.

Entsprechend den Hülsen 8 mit den Bohrungen B hat das zweite Gehäuseteil 2 eine Vielzahl von Zapfen Z21 bis Z2n und Z11 bis Z1n. Die Zapfen Z21 bis Z2n sind den Bohrungen B21 bis B2n zugeordnet und die Zapfen Z11 bis Z1n den Bohrungen B11 bis B1n.

Die Abstände benachbarter Zapfen Z zueinander sind mit L31 bis L3n und L41 bis L4n bezeichnet. Die Mittelachsen der Zapfen Z21 bis Z2n und die der Zapfen Z11 bis Z1n sind jeweils ebenfalls in geradlinigen Reihen nahe dem umlaufenden Rand 15 angeordnet und haben zu diesem einen geringen Abstand, der in der Größenordnung des Durchmessers der Zapfen liegt. Die dem Boden 14 zugewandten Enden der Zapfen Z sind über Versteifungsrippen 21 mit dem umlaufenden Rand 15 oder dem Boden 14 einstückig verbunden.

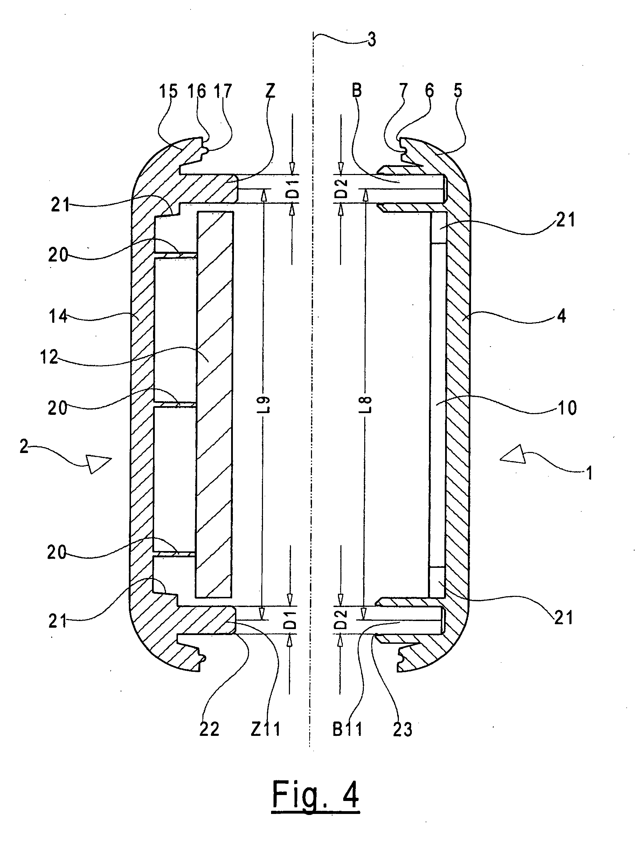

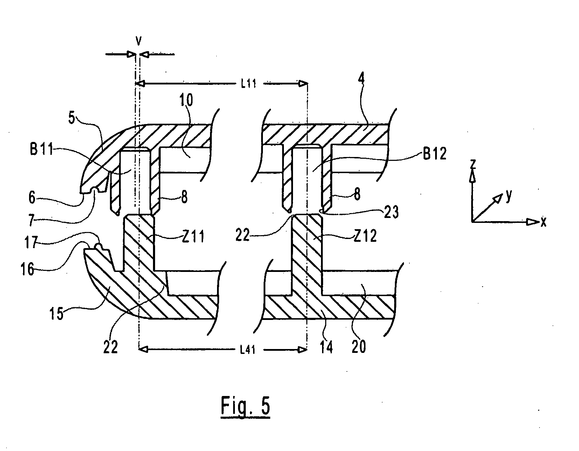

Um die beiden Gehäuseteile 1 und 2 allein über die Zapfen Z und die Bohrungen B fest miteinander verbinden zu können, sind folgende Maßnahmen vorgesehen, was im Zusammenhang mit Fig. 4 und 5 erläutert wird. Die dort dargestellten Zapfen Z sind zylindrisch und haben einen Durchmesser D1. Die zugeordneten Bohrungen B in den Hülsen 8 sind ebenfalls zylindrisch und haben einen Durchmesser D2. Wichtig für die Erfindung ist, daß der Durchmesser D1 der Zapfen Z größer ist als der Durchmesser D2 der Bohrungen B und zwar etwa um 0,7% bis 1% des Durchmessers D1 der Zapfen Z. Da die Zapfen Z einstückig am zweiten Gehäuseteil 2 angebracht sind und daher ebenfalls aus Kunststoff, sind sie aufgrund der Materialeigenschaften des Kunststoffes elastisch. Aus gleichen Grunde sind auch die Hülsen 8 elastisch, so daß die Zapfen Z trotz des größeren Durchmessers D1 in die Bohrungen B eingeführt werden können, womit sich bereits bezogen auf Kräfte in Richtung der Mittelachse der Zapfen Z und der Bohrungen B eine reibschlüssige Verbindung und bezogen auf Kräfte in der Verbindungsebene 3 eine formschlüssige Verbindung ergibt.

In einem konkreten Ausführungsbeispiel beträgt der Durchmesser der Zapfen 2,52mm während der Durchmesser der Bohrungen 2,50mm beträgt.

Um das Einführen der Zapfen Z in die Bohrungen B zu gewährleisten, haben die Zapfen Z an ihrem freien Ende eine Fase 22. Zusätzlich haben die Bohrungen B an ihrem freien Ende eine Aufweitung 23. Damit können die Zapfen Z auch dann in die Bohrung B eingeführt werden, wenn ihre wechselseitigen Mittelachsen nicht exakt miteinander fluchten.

Zur weiteren Verbesserung der Verbindung zwischen den Zapfen Z und den Bohrungen B und damit auch zur weiteren Versteifung der beiden Gehäuseteile 1 und 2 sieht die Erfindung vor, daß die Abstände benachbarter Zapfen und die Abstände der den Zapfen zugeordneten benachbarten Bohrungen ungleich sind und zwar um ein solches Maß, daß zwar die Zapfen in die zugeordneten Bohrungen einsetzbar sind, jedoch die Zapfen und Bohrungen aufgrund der ungleichen Abstände elastisch gegeneinander verspannt sind. Dies sei am Beispiel der Zapfen Z11 und Z12 und der zugeordneten Bohrungen B11 und B12 unter Bezugnahme auf Fig. 5 näher erläutert. Die benachbarten Zapfen Z11 und Z12 haben zueinander den Abstand L41. Die benachbarten Bohrungen B11 und B12 haben zueinander den Abstand L11. Diese Abstände beziehen sich jeweils auf die Mittelachsen der Bohrungen bzw. Zapfen. Diese Abstände L11 und L41 sind gemäß einem wichtigen Merkmal der Erfindung nicht identisch, sondern haben einen Versatz V gegeneinander, der in Fig. 5 dargestellt ist. In diesem Beispiel ist der Abstand L41 der beiden benachbarten Zapfen Z11 und Z12 um das Maß V kleiner als der Abstand L11 zwischen den benachbarten Bohrungen B11 und B12. Werden nun die Zapfen Z11 und Z12 in die Bohrungen B11 und B12 eingeführt, so treten Längskräfte in Richtung des Pfeiles X auf, die die Zapfen, die Hülsen und über die Versteifungsrippen auch die Ränder 5, 15 und die Böden 4, 14 der beiden Gehäuseteile 1 und 2 elastisch verformen und die Zapfen/Hülsen-Verbindungen in der Verbindungsebene 3, die parallel zur in Fig. 5 dargestellten X-Richtung liegt, verspannen.

Durch dieses Verspannen wird einerseits eine zusätzliche Reibungskraft zwischen Zapfen und zugeordneten Bohrungen im Sinne einer Haftreibung gegenüber einer Bewegung in Z-Richtung, d.h. parallel zu den Mittelachsen der Zapfen und Bohrungen, aufgebracht, was ein (unbeabsichtigtes) Lösen der Verbindungen erschwert. Andererseits wird aber auch durch dieses Verspannen die Biegesteifigkeit und die Torsionssteifigkeit der beiden Gehäuseteile wesentlich erhöht.

Dieses Prinzip der Verspannung kann auch alternativ oder kumulativ dadurch erreicht werden, daß die in Fig. 4 dargestellten Abstände L8 und L9 ungleich sind. Beispielsweise ist also der Abstand zwischen den Mittelachsen der Bohrungen B11 und B21 (Fig. 2) und der der Zapfen Z11 und Z21 (Fig. 3) ungleich, so daß auch ein Verspannen in Y-Richtung (Fig. 5) stattfindet.

Die Größe des Versatzes V (Fig. 5) ist auf die Materialeigenschaften des verwendeten Kunststoffes abzustimmen, um eine Überbeanspruchung des Materials und insbesondere ein Brechen der Zapfen oder der Hülsen zu vermeiden. Auch sind die Fasen 22 an den Zapfen und die Aufweitungen 23 an den Bohrungen auf den Versatz V abzustimmen, so daß auch bei maximal möglichem Versatz die Fasen 22 noch mit den Rändern der Aufweitungen 23 in Kontakt kommen und die Zapfen somit eingeführt werden können.

Sind die beiden Gehäuseteile 1 und 2 vollständig miteinander verbunden, so greift der Vorsprung 17 an dem umlaufenden Rand 15 in die Vertiefung 7 an dem umlaufenden Rand 5 und die beiden Endflächen 6 und 16 liegen ohne Spalt dicht aneinander. Der Eingriff des Vorsprunges 17 in die Vertiefung 7 bildet zusätzlich eine formschlüssige Verbindung der beiden umlaufenden Ränder in der X/Y-Ebene, d.h. der Verbindungsebene 3, und sorgt für eine weitere Versteifung des Kunststoffgehäuses. Zusätzlich wirkt der Eingriff des Vorsprunges 17 in die Vertiefung 7 auch als Dichtung gegen Eindringen von Schmutz und Staub.

Der genannte Versatz V beträgt in einem bevorzugten Ausführungsbeispiel der Erfindung 0,7 bis 1 % des Durchmessers D1 der Zapfen Z. Wird der Versatz in x-und y-Richtung vorgenommen, so ist er als Vektor mit x- und y-Komponente zu bestimmen.

Bevorzugt ist allerdings, den Versatz nur in X-Richtung, d.h. Längsrichtung des Gehäuses, vorzusehen, wenn das Gehäuse, wie in den Fig. 1 bis 3 dargestellt, langgestreckt ist, d.h. eine größere Länge als Breite hat, da die Biegesteifigkeit bezogen auf die Längserstreckung wichtiger ist als bezogen auf die Quererstreckung.

Bei der Fertigung von Spritzgußwerkzeugen für die beiden Gehäuseteile 1 und 2 ist noch darauf zu achten, daß die beiden Gehäuseteile 1 und 2 aufgrund der unterschiedlichen Ausgestaltung der Durchbrüche 9 und der Versteifungsrippen 10, 20, 22 beim Aushärten des Kunststoffes unterschiedliches Schrumpfungsverhalten zeigen können. Auch haben unterschiedliche Kunststoffe unterschiedliche Schrumpfungsverhalten. Bei ABS beträgt das Schrumpfungsmaß etwa 0,5 %, bei Polycarbonat dagegen 0,65 bis 0,70 %. Auch spielt die Wandstärke der Versteifungsrippen 10, 20, 22 eine Rolle. Bevorzugt haben die Versteifungsrippen 10, 20, 22 eine Wandstärke von 2/3 der Wandstärke der Böden 4 und 14. Haben die Böden 4 und 14 eine Wandstärke von 2 mm, so gibt man den Rippen eine Wandstärke von maximal 1,33 mm. Bevorzugt haben die Versteifungsrippen eine Formschräge. Am unteren Ende haben sie bevorzugt eine Wandstärke von 1,2 mm und am freien Ende von 0,8 mm.

Zusammengefaßt schafft die Erfindung ein formstabiles und extrem einfaches zu montierendes Kunststoffgehäuse, das sich zwar nur sehr schwer aber trotzdem zerstörungsfrei öffnen läßt.

## Patentansprüche

1. Kunststoffgehäuse für elektronische Geräte, insbesondere für Fernsteuerungen, mit einem ersten Gehäuseteil (1) und einem zweiten Gehäuseteil (2), die mittels einer Vielzahl von Zapfen (Z) an einem der Gehäuseteile (1, 2) und einer Vielzahl von den Zapfen (Z) zugeordneten Hülsen (8) mit Bohrungen (B) am anderen Gehäuseteil (2, 1) miteinander verbunden sind,
**dadurch gekennzeichnet,**
**daß** der Durchmesser (D1) der Zapfen (Z) größer ist als der Durchmesser (D2) der Bohrungen (B), daß die Abstände (L31-L3n, L41-L4n) benachbarter Zapfen (Z) und die Abstände (L11-L1n, L21-L2n) der den Zapfen (Z) zugeordneten Bohrungen (B) ungleich sind um ein solches Maß (V), daß die Zapfen (Z) in die zugeordneten Bohrungen (B) einsetzbar sind, jedoch die Zapfen (Z) und die Bohrungen (B) aufgrund der ungleichen Abstände (V) elastisch gegeneinander verspannt sind.

2. Kunststoffgehäuse nach Anspruch 1, **dadurch gekennzeichnet,**
**daß** der Durchmesser (D1) der Zapfen (Z) um 0,7 % bis 1 % größer ist als der Durchmesser (D2) der Bohrungen (B).

3. Kunststoffgehäuse nach Anspruch 2, **dadurch gekennzeichnet,**
**daß** der Durchmesser (D1) der Zapfen (Z) 2,52 mm und der Durchmesser (D2) der Bohrungen (B) 2,50 mm beträgt.

4. Kunststoffgehäuse nach einem der Ansprüche 1 bis 3, **dadurch gekennzeichnet,**
**daß** die Abstände (L31-L3n, L41-L4n) benachbarter Zapfen (Z) und die Abstände (L11-L1n, L21-L2n) zugeordneter benachbarter Bohrungen (B) um 0,7 bis 1,0 % des Durchmessers (D1) der Zapfen (Z) voneinander abweichen.

5. Kunststoffgehäuse nach einem der Ansprüche 1 bis 3, **dadurch gekennzeichnet,**
**daß** die Zapfen (Z) und die Bohrungen (B) in Reihen parallel zu Rändern (5, 15) der Gehäuseteile (1, 2) angeordnet sind.

6. Kunststoffgehäuse nach Anspruch 4, **dadurch gekennzeichnet,**
**daß** die Abstände (L8, L9) von einander gegenüberliegenden Zapfen (Z) und einander gegenüberliegenden Bohrungen (B) ungleich sind.

7. Kunststoffgehäuse nach einem der Ansprüche 1 bis 5, **dadurch gekennzeichnet,**
**daß** der Abstand der Zapfen (Z) zu einer nach innen weisenden Kante des umlaufenden Randes (16) maximal dem Durchmesser (D1) der Zapfen (Z) entspricht.

8. Kunststoffgehäuse nach einem der Ansprüche 1 bis 6, **dadurch gekennzeichnet,**
**daß** die Zapfen (Z) und die Hülsen (8) mit Bohrungen (B) einstückig an den Gehäuseteilen (1, 2) angeformt sind und über senkrecht von einem Boden (4, 14) der Gehäuseteile (1, 2) abstehende Versteifungsstege (21) am Boden (4, 14) und/oder dem umlaufenden Rand (5, 15) abgestützt sind.

## Claims

1. A plastic housing for electronic devices, in particular, for remote controls, comprising:
a first housing part (1) and a second housing part (2), which are connected with one another by means of a plurality of pins (Z) on one of the housing parts (1,2) and by a plurality of boreholes (B) assigned to the pins (Z) on the other housing part (2,1) **characterized in that**
the diameter (D1) of the pins (Z) is larger than the diameter (D2) of the boreholes (B),
**in that** distances (L31-L3n, L41-L4n) of adjacent pins (Z) and distances (L11-L1n, L21-L2n) of adjacent boreholes correlated with the pins are unequal to such an extent (V) that the pins (Z) can be inserted into the correlated boreholes (B), but the pins (Z) and the boreholes (B) are elastically braced against one another because of the unequal distances (V).

2. The plastic housing according to claim 1, **characterized in that** the diameter (D1) of the pins (Z) is larger by 0.7% to 1% than the diameter (D2) of the boreholes (B).

3. The plastic housing according to Claim 2, **characterized in that** the diameter (D1) of the pins (Z) is 2.52 mm and the diameter (D2) of the boreholes (B) is 2.50 mm.

4. The plastic housing according to one of claim1 to 3, **characterized in that** the distances (L31-L3n, L41-L4n) between the adjacent pins (Z) and the distances (L11-L1n, L21-L2n) between the correlated adjacent boreholes (B) differ from one another by 0.7 to 1.0% of the diameter (D1) of the pins (Z) .

5. The plastic housing according to one of claims 1 to 3, **characterized in that** the pins (Z) and the boreholes (B) are arranged in rows parallel to edges (5, 15) of the housing parts (1, 2) .

6. The plastic housing according to claim 4, **characterized in that** the distances (L8, L9) between pins (Z) opposite one another and the boreholes (B) opposite one another are unequal.

7. The plastic housing according to one of claims 1 to 5, **characterized in that** the distance between the pins (Z) and an inward edge of a surrounding edge (16) is, as a maximum, the diameter (D1) of the pins (Z).

8. The plastic housing according to one of claims 1 to 6, **characterized in that** the pins (Z) and the sleeves (8) with boreholes (B) are formed integrally on the housing parts (1, 2) and are supported via reinforcement ribs (21) on a bottom (4, 14), which ribs stand out vertically from the bottom (4, 14), and/or via the surrounding edge (5, 15).

## Revendications

1. Boîtier en plastique pour des appareils électroniques, en particulier pour des télécommandes, comprenant une première partie de boîtier (1) et une deuxième partie de boîtier (2), lesquelles sont assemblées l'une à l'autre au moyen d'une pluralité de chevilles (Z) sur l'une des parties de boîtier (1, 2) et au moyen d'une pluralité de douilles (8), en correspondance des chevilles (Z) et comprenant des alésages (B) sur l'autre partie de boîtier (2, 1),
**caractérisé**
**en ce que** le diamètre (D1) des chevilles (Z) est plus grand que le diamètre (D2) des alésages (B),
**en ce que** les espacements (L31-L3n, L41-L4n) entre les chevilles (Z) adjacentes et les espacements (L11-L1n, L21-L2n) entre les alésages (B) en correspondance des chevilles (Z) sont inégaux selon une proportion (V) telle que les chevilles (Z) peuvent être insérées dans les alésages (B) correspondants, les chevilles (Z) et les alésages (B) étant toutefois contraints les uns par rapport aux autres de manière élastique du fait des espacements (V) inégaux.

2. Boîtier en plastique selon la revendication 1, **caractérisé en ce**
**que** le diamètre (D1) des chevilles (Z) est plus grand que le diamètre (D2) des alésages (B) selon une proportion allant de 0,7 % à 1 %.

3. Boîtier en plastique selon la revendication 2, **caractérisé en ce**
**que** le diamètre (D1) des chevilles (Z) est de 2,52 mm, et en ce que le diamètre (D2) des alésages (B) est de 2,50 mm.

4. Boîtier en plastique selon l'une quelconque des revendications 1 à 3, **caractérisé en ce**
**que** les espacements (L31-L3n, L41-L4n) entre les chevilles (Z) adjacentes et les espacements (L11-L1n, L21-L2n) entre les alésages (B) adjacents correspondants diffèrent les uns des autres selon une proportion allant de 0,7 à 1 % du diamètre (D1) des chevilles (Z).

5. Boîtier en plastique selon l'une quelconque des revendications 1 à 3, **caractérisé en ce**
**que** les chevilles (Z) et les alésages (B) sont disposés selon des rangées parallèles par rapport à des bords (5, 15) des parties de boîtier (1, 2).

6. Boîtier en plastique selon la revendication 4, **caractérisé en ce**
**que** les espacements (L8, L9) entre les chevilles (Z) se faisant face et entre les alésages (B) se faisant face sont inégaux.

7. Boîtier en plastique selon l'une quelconque des revendications 1 à 5, **caractérisé en ce**
**que** l'espacement entre les chevilles (Z) et une arête, orientée vers l'intérieur, du bord (16) périphérique correspond au maximum au diamètre (D1) des chevilles (Z).

8. Boîtier en plastique selon l'une quelconque des revendications 1 à 6, **caractérisé en ce**
**que** les chevilles (Z) et les douilles (8) comprenant des alésages (B) sont formées d'un seul tenant sur les parties de boîtier (1, 2), et s'appuient au niveau du fond (4, 14) et/ou au niveau du bord (5, 15) périphérique par l'intermédiaire de nervures de renforcement (21) faisant saillie de manière perpendiculaire d'un fond (4, 14) des parties de boîtier (1, 2).
